# EUROPEAN PATENT SPECIFICATION

(11) **EP 0 576 773 B1**
(45) Date of publication and mention of the grant of the patent: **13.09.1995**
(21) Application number: 92830339.5
(22) Date of filing: 30.06.1992
(51) Int. Cl.: H01L 27/115

(54) **Integrated circuit entirely protected against ultraviolet rays**
Integrierte Schaltung mit vollständigem Schutz gegen Ultraviolettstrahlen
Circuit intégré entièrement protégé contre des rayons ultra-violets

(43) Date of publication of application: 05.01.1994
(73) Proprietor: SGS-THOMSON MICROELECTRONICS s.r.l., 20041 Agrate Brianza (Milano) (IT)
(72) Inventor: Caprara,Paolo, I-20149 Milano (IT); Camerlenghi,Emilio, I-24100 Bergamo (IT)
(74) Representative: Checcacci, Giorgio

(56) References cited:
- EP-A- 0 227 549
- EP-A- 0 433 174

## Description

This invention relates to an integrated circuit which is fully protected from UV radiation, being of a type implemented in MOS technology on a semiconductor substrate and including:
- at least one memory cell with a floating gate transistor having drain and source areas separated by a channel region, and first and second polysilicon gate terminals,
- a metallic mask covering said cell,
- a diffused region (14) defining a closed loop path on the substrate (4) surface all around the transistor (3) and having said mask peripherally connected thereto in an unbroken fashion.

The field of application of this invention relates, particularly but not solely, to CMOS technology integrated circuits incorporating EPROM memory cells with floating gate MOS transistors, and the description to follow will make reference to this field of application for simplicity of illustration.

As is known, non-volatile memory cells of the EPROM type are written in electrically and cleared by means of ultraviolet beams. It is also well recognized that in the manufacture of integrated circuits incorporating EPROM memory cells, allowance must be made for spare or redundant portions, i.e. portions which can replace memory areas rendered inoperative by any designing flaws. To provide such redundancy, "fuse" devices must be used which, when traversed by a current of a predetermined value, would "melt down" and open the circuit in specified areas thereof.

This allows access paths to be established which either enable or inhibit readout of selected memory areas.

Heretofore, such "fuses" consisted of memory cells of the EPROM type, i.e. floating gate MOS devices responsive to UV radiation in the sense that, when exposed to the radiation, they lose their electric charge and, consequently, the information represented thereby.

In such fuse-like functional applications, however, the memory circuit requires protection against ultraviolet light. In this respect, the prior art has proposed of screening the EPROM cell by means of a metallization mask, e.g. one formed from an aluminum foil connected to the substrate of the semiconductor IC.

This prior approach provides for the EPROM cell to be covered with a squared up conductive foil of aluminum which is connected along three sides to the silicon substrate, as previously made conductive by an appropriate doping step.

In this way, the UV radiation will be reflected from the foil, and the corresponding EPROM cell may be regarded as an UPROM (Unerasable Programmable ROM) structure.

While being in many ways beneficial, that approach has, however, a drawback in that at least one side of the aluminum covering is left of necessity exposed, in order to permit the drain, source, and floating gate terminals of the MOS transistor incorporated to the memory cell to be biased.

As a result, ultraviolet light is admitted inside through this unconnected side to the substrate and allowed to propagate therein until it indirectly reaches the floating gate.

As a consequence, the immunity of a cell so protected to UV radiation is bound to only last a few weeks.

To obviate this drawback, the prior art has proposed that meanders of suitably doped silicon be formed on the semiconductor for communicating the bias to the aforesaid drain, source and gate terminals.

Along these meanders, the ultraviolet light is reiterately reflected and absorbed such that it can no longer reach the floating gate with sufficient intensity to remove the charge therefrom and, hence, alter its logic value.

But this prior art approach has the disadvantage that it takes up valuable space on the integrated circuit.

To avoid this disadvantage it has been provided a prior art solution disclosed in the European patent application No. EP-A-0 433 174 which relates to an integrated circuit entirely protected against UV. This document specifically relates to an EEPROM memory cell having a transistor with a floating gate GF1 realized by a polysilicon layer and a control gate GC1 realized by a diffusion layer.

A diffused region Ad defining a closed loop path on the substrate surface all around the cell is connected in an unbroked fashion to a mask covering the memory cell

A first well region Ca4 extending in the substrate is used to contact the diffused control gate region inside the substrate.

This solution may be useful for EEPROM memory devices but it's not applicable to EPROM devices with comprise a double polysilicon gate terminal.

Another solution is disclosed in the European patent application No. EP-A-0 227 549 which relates to an EPROM memory cell protected against ultraviolet rays by a mask serving also as a source electrode.

However, this document doesn't relate to a memory structure completely protected against ultraviolet rays and it doesn't teach or suggest how to provide a connection between a polysilicon layer forming the gate terminal of the memory transistor and any kind of well region.

The underlying technical problem of this invention is to provide an integrated circuit which is fully protected from UV radiation and has such compact-design features as to overcome the aforementioned drawbacks besetting the prior art. This problem is solved by the device according to claim 1. Further embodiments of the present invention are defined in the dependent claims. The features and advantages of the inventive circuit will become apparent from the following detailed description of an embodiment thereof, given by way of non-limitative example with reference to the accompanying drawings.

### In the drawings:

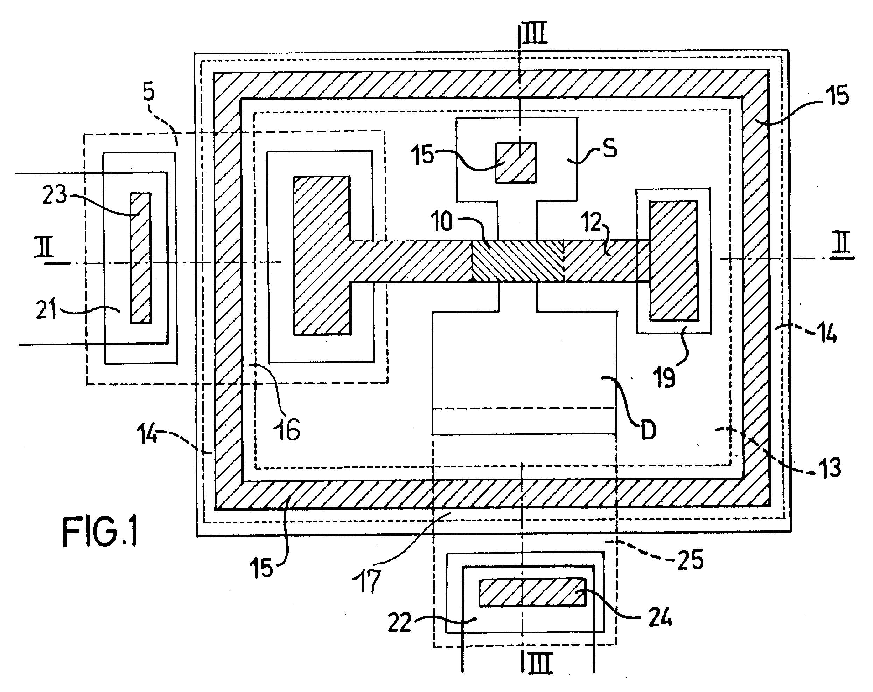

Figure 1 is a top plan view showing schematically the integrated circuit of this invention;
Figure 2 is a schematic cross-section view of the circuit in Figure 1, taken along line II-II; and
Figure 3 is a schematic cross-section view of the circuit in Figure 1, taken along line III-III.

With reference to the drawing views, generally and schematically shown at 1 is an integrated circuit embodying this invention.

The circuit 1 comprises at least one memory cell implemented in either MOS or CMOS technology and consisting of a floating gate MOS transistor 3.

The circuit 1 is formed over a semiconductor silicon substrate 4 wherein first 5 and second 25 diffused regions of the N-well type are formed the significance whereof will become apparent later in this description.

Taking the horizontal plane of the substrate 4 as the reference plane, these regions 5 and 25, better known as wells, extend substantially along mutually perpendicular axes.

Advantageously, the circuit 1 is also provided with a diffused region 14 defining a closed loop path and being doped similar to the substrate, e.g. using dopant of the P+ type. This ring-like region 14 is formed on the surface of the substrate 4 and fully encircles the cell, atholl-fashion. Respective portions 16 and 17 of this region 14 also intersect the wells 5 and 25 superficially.

Formed on the first well 5 are two discrete active areas 20 and 21 which are doped N+ and located on opposed sides of portion 16 of the diffused region 14.

The second well 25 also includes an active area 22 being doped N+ and formed outside the ring region 14.

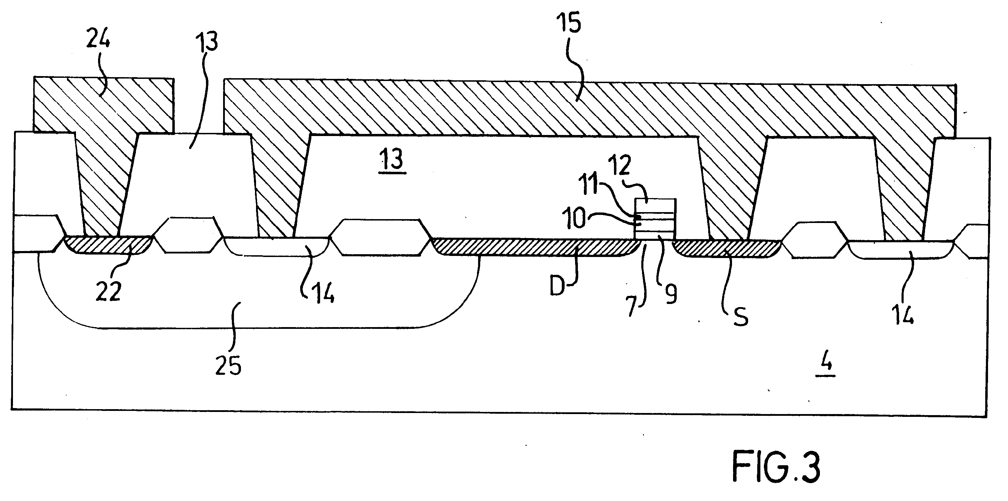

As shown in Figure 3, the transistor 3 is implanted a channel 7 which is bordered by opposed source and drain N+ active areas denoted by the reference characters S and D. The drain active area D extends as far as the second well 25 and forms a junction therewith.

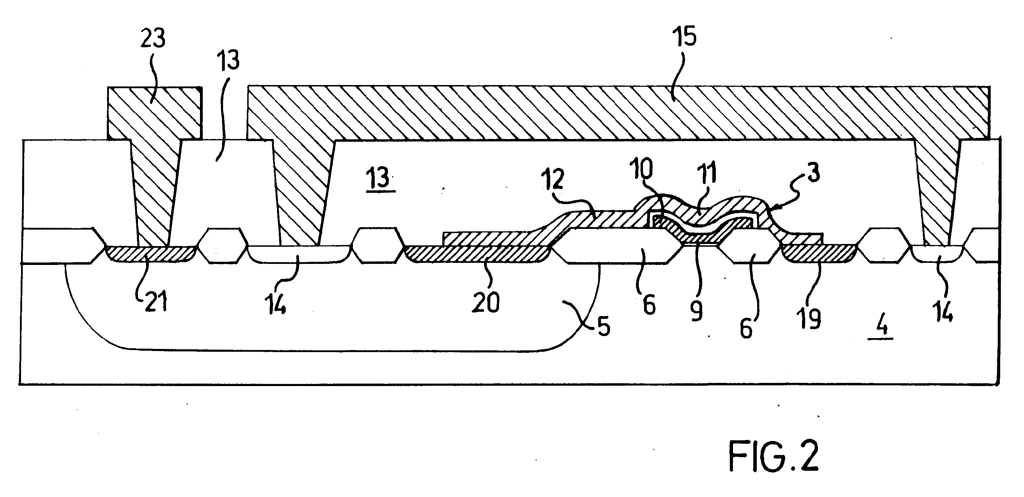

This same channel implant 7 is shown in Figure 2 on a different vertical section plane, and is bound by isolating regions 6 which are formed from so-called field oxide.

In addition, a thin layer 9 of gate oxide is grown over the channel 7, and this basic structure is covered with a first layer 10 of polycrystalline silicon, in turn covered with a dielectric layer 11. The layer 10 forms the so-called floating gate of transistor 3.

A second layer 12 of polycrystalline silicon covers the entire structure so far described and extends from the first active region 20 of the well 5 to a third active region 19 formed beside transistor 3, on the side away from well 5. This layer 12, which is connected directly to these areas 20 and 19, constitutes the control gate terminal for the transistor 3.

An intervening dielectric layer 13, grown on the surface of the substrate 4 and over the transistor 3, protects and isolates superficially the whole circuit 1.

Advantageously, according to the invention, a metallic mask 15 is provided which may be made of aluminum and is embedded peripherally in the substrate 4 to cover the memory cell. More specifically, the mask 15 covers the intervening dielectric layer 13 above the cell and is connected peripherally in an unbroken fashion to the ring region 14 so as to penetrate said dielectric layer 13.

Thus, the region 14 will provide an active area of contact with the substrate 4 for the metallization mask 15, which is adapted to protect the cell from UV radiation.

The mask 15 is also connected, again through the dielectric layer 13, to the active source area S of transistor 3, to also function as the source electrode thereof.

It may be appreciated from the foregoing description that the memory cell is substantially enclosed within a protective shell comprising the substrate 4 and metallization mask 15. The latter functions to effectively screen off the UV radiation by presenting a reflective surface thereto.

Also apparent is, however, that the drain, source and gate terminals of transistor 3 are, in turn, enclosed within said protective shell, and that adequate bias must be provided therefor. For this purpose, the wells 5 and 25 have been provided in accordance with this invention.

Each of these wells 5 and 25 extends in the substrate 4 beyond the ring perimeter P+ consisting of the diffused region 14, and toward the cell. They form substantially two diodes having reversed bias compared to circuit 1 operating voltages and do not drive current to the substrate 4.

The second well 25 biases the drain terminal D of transistor 3.

The first well 5 allows the control gate of transistor 3 to become biased as a result of the direct contact established between the second layer 12 of polycrystalline silicon and the first active area 20 incorporated to the well 5. The active area 20 is doped by diffusion through the layer of polycrystalline silicon as previously deposited and doped.

The above-mentioned direct contact and N+ diffusion of the well 5 ensure electrical continuity with the second active area 21 incorporated to the well 5, but externally of the diffused region 14.

In essence, this second active area 21 may be regarded for all purposes as the control gate of transistor 3.

Likewise, the active area 22 incorporated to the second well 25 functions as the drain electrode for the transistor 3. Each active area, 21 or 22, is obviously reached by a corresponding metallization electrode 23, 24.

It should be noted, lastly, that present in the substrate 4 is also a protection diode provided by the active area 19 associated with the cell. This active area 19 is also connected directly to the layer 12 of polycrystalline silicon, but is reverse biased compared to the operating voltages of the transistor 3; it serves to protect the dielectric layers 9 and 11 of the control gate during the circuit manufacturing process.

The diode 19 becomes operative subsequently to bounding by plasma etching the layer 12 of polycrystalline silicon which forms the control gate. Its presence prevents the floating gate from being charged during the manufacturing process, and this because any charge trapped in would be no longer removable by UV radiation in view of the circuit of this invention having been effectively protected from this very radiation.

The inventive circuit solves the technical problem and provides full screening from UV radiation by that the metallization mask 15 is connected peripherally to the substrate all around it, and fully covers the memory cell. This does not impair, however, proper biasing of the floating gate MOS transistor incorporated to the cell by virtue of the combined provision of wells 5 and 25 being effective to transfer the bias from external terminals to the UV radiation screening shell.

The structure according to the invention further affords a major advantage in that it can be made highly compact and would occupy a smaller area in the circuit than prior art approaches. It also lends itself for association in modular form with other similar memory cells sharing the source and control gate electrodes.

It should be also noted that the inventive structure is compatible with those technologies which provide for the contacts to be formed by filling methods based on the deposition and subsequent removal of material from those portions which represent no contact portions. This is made possible by the contact pattern exhibiting no crossovers from which the filling material might fail to be removed.

Further, no additional masks are required to make such a structure.

## Claims

1. An integrated circuit fully protected from UV radiation, being of a type implemented in MOS technology on a semiconductor substrate (4) and including:
- at least one memory cell with a floating gate transistor (3) having drain and source areas separated by a channel region, and floating and control gate terminals,
- a metallic mask covering said cell,
- a diffused region (14) defining a closed loop path on the substrate surface all around the transistor (3) and having said mask peripherally connected thereto in an unbroken fashion,
- first (5) and second (25) wells extending laterally in the substrate (4) from inside said closed loop path (14)
to outside said closed loop path (14), the first (5) of said wells being connected directly to the control gate terminal (12) of the transistor (3),
characterised in that said floating and control gate terminals form a stacked structure of first and second polysilicon layers respectively and that said mask (15) contacts the source area (S) of the transistor (3).

2. An integrated circuit according to Claim 1, characterized in that said second well (25) extends from said drain area (D) of the transistor (3) to another active area (22) outside the closed loop path defined by said diffused region (14).

3. An integrated circuit according to Claim 1, characterized in that said diffused region (14) is ring-shaped.

4. An integrated circuit according to Claim 1, characterized in that said first well (5) comprises first (20) and second (21) active areas on opposed sides of said diffused region (14), said first active area (20) being in direct contact with a deposition layer (12) constituting the control gate terminal of the transistor (3).

5. An integrated circuit according to Claim 1, characterized in that it comprises a protection diode (19) incorporated to the circuit internally to the closed loop path defined by said diffused region (14).

6. An integrated circuit according to Claim 5, characterized in that said diode consists of an active area (19) formed adjacent to said cell in direct contact with the control gate terminal of the transistor (3).

7. An integrated circuit according to Claim 5, characterized in that said diode (19) is reverse biased at the normal operating voltage of said transistor (3).

## Patentansprüche

1. Vollständig gegen UV-Strahlung geschützte integrierte Schaltung des Typs, der in MOS-Technologie auf einem Halbleitersubstrat (4) ausgeführt ist, umfassend:
- mindestens eine Speicherzelle mit einem Floating-Gate-Transistor (3), dessen Drain- und Source-Zonen durch eine Kanalzone voneinander getrennt sind, und der Floating- und Steuergateanschlüsse besitzt,
- eine die Zelle überdeckende Metallmaske,
- eine Diffusionszone (14), die eine um den gesamten Transistor (3) herumführende geschlossene Schleife auf der Substratoberfläche definiert und am Umfang mit der Maske in nicht-unterbrochener Weise verbunden ist,
- eine erste (5) und eine zweite (25) Vertiefung, die sich in dem Substrat (4) in seitliche Richtung aus dem Inneren der geschlossenen Schleife (14) nach außerhalb der geschlossenen Schleife (14) erstrecken, wobei die erste (5) der Vertiefungen direkt an den Steuergateanschluß (12) des Transistors (3) angeschlossen ist,
**dadurch gekennzeichnet,** daß die Floating- und Steuergateanschlüsse einen Stapelaufbau aus einer ersten bzw. einer zweiten Polysiliziumschicht bilden, und daß die Maske (15) die Sourcezone (S) des Transistors (3) kontaktiert.

2. Integrierte Schaltung nach Anspruch 1, **dadurch gekennzeichnet,** daß die zweite Vertiefung (25) sich von der Drainzone (D) des Transistors (3) aus zu einer weiteren aktiven Zone (22) außerhalb der geschlossenen Schleife erstreckt, die durch die Diffusionszone (14) definiert wird.

3. Integrierte Schaltung nach Anspruch 1, **dadurch gekennzeichnet,** daß die Diffusionszone (14) ringförmig ist.

4. Integrierte Schaltung nach Anspruch 1, **dadurch gekennzeichnet,** daß die erste Vertiefung (5) eine erste (20) und eine zweite (21) aktive Zone an einander entgegengesetzten Seiten der Diffusionszone (14) aufweist, von denen die erste aktive Zone (20) in direkter Berührung mit einer niedergeschlagenen Schicht (12) steht, welche den Steuergateanschluß des Transistors (3) bildet.

5. Integrierte Schaltung nach Anspruch 1, **dadurch gekennzeichnet,** daß sie eine Schutzdiode (19) beinhaltet, die in die Schaltung eingebaut ist, die sich im Inneren der durch die Diffusionszone (14) definierten geschlossenen Schleife befindet.

6. Integrierte Schaltung nach Anspruch 5, **dadurch gekennzeichnet,** daß die Diode aus einer aktiven Zone (19) besteht, die benachbart zu der Zelle ausgebildet ist und in direktem Kontakt mit dem Steuergateanschluß des Transistors (3) steht.

7. Integrierte Schaltung nach Anspruch 5, **dadurch gekennzeichnet,** daß die Diode (19) bei der normalen Betriebsspannung des Transistors (3) in Sperrichtung vorgespannt ist.

## Revendications

1. Circuit intégré entièrement protégé contre des rayons ultraviolets, d'un type réalisé en technologie MOS sur un substrat semi-conducteur (4) et qui comprend :
- au moins une cellule de mémoire avec un transistor (3) à grille flottante ayant des zones de drain et de source séparées par une zone de canal, et des électrodes de grille flottante et de grille de commande,
- un masque métallique recouvrant ladite cellule,
- une zone diffusée (14) définissant un trajet en boucle fermée à la surface du substrat tout autour du transistor (3) et ledit masque y étant connecté périphériquement de manière ininterrompue,
- un premier (5) et un second (25) caissons s'étendant latéralement dans le substrat (4) de l'intérieur dudit trajet en boucle fermée (14), vers l'extérieur dudit trajet en boucle fermée (14), le premier (5) desdits caissons étant connecté directement à l'électrode de grille de commande (12) du transistor (3),
caractérisé en ce que lesdites électrodes de grille flottante et de grille de commande forment une structure multicouche composée respectivement d'une première et d'une seconde couches de polysilicium et en ce que ledit masque (15) touche la zone de source (S) du transistor (3).

2. Circuit intégré selon la revendication 1, caractérisé en ce que le second caisson (25) mentionné s'étend de ladite zone du drain (D) du transistor (3) vers une autre zone active (22) à l'extérieur du trajet en boucle fermée défini par ladite zone diffusée (14).

3. Circuit intégré selon la revendication 1, caractérisé en ce que ladite zone diffusée (14) est en forme d'anneau.

4. Circuit intégré selon la revendication 1, caractérisé en ce que ledit premier caisson (5) comprend une première (20) et une seconde (21) zones actives sur les côtés opposés de ladite zone diffusée (14), ladite première zone active (20) étant directement en contact avec une couche de dépôt (12) constituant l'électrode de grille de commande du transistor (3).

5. Circuit intégré selon la revendication 1, caractérisé en ce qu'il comprend une diode de protection (19) incorporée au circuit à l'intérieur du trajet en boucle fermée défini par ladite zone diffusée (14).

6. Circuit intégré selon la revendication 5, caractérisé en ce que ladite diode consiste en une zone active (19) formée adjacente à ladite cellule en contact direct avec l'électrode de grille de commande du transistor (3).

7. Circuit intégré selon la revendication 5, caractérisé en ce que ladite diode (19) est polarisée en inverse à la tension normale de fonctionnement dudit transistor (3).
